# EUROPEAN PATENT APPLICATION

(11) **EP 4 671 917 A1**
(43) Date of publication of application: **31.12.2025**
(21) Application number: 23930024.7
(22) Date of filing: 30.11.2023
(51) Int. Cl.: G06F 1/18

(54) **ELECTRONIC DEVICE AND HEAT DISSIPATION SYSTEM**

(30) Priority: 30.03.2023 CN 202310365954
(71) Applicant: Huawei Technologies Co., Ltd., Shenzhen, Guangdong 518129 (CN)
(72) Inventor: CHEN, Jiaxiang, Shenzhen, Guangdong 518129 (CN); JIN, Ke, Shenzhen, Guangdong 518129 (CN); XU, Weiqiang, Shenzhen, Guangdong 518129 (CN)
(74) Representative: Körber, Martin Hans
(86) International application number: PCT/CN2023/135609
(87) International publication number: WO 2024/198458

(57) **Abstract**

This application provides an electronic device and a heat dissipation system. The electronic device includes a plurality of shelves. Each shelf includes a first processor, a first mainboard, and a connector. The first mainboard in any shelf is separately connected to the first processor and the connector that are located in the same shelf. The connector in a first shelf is separately connected to the connector in at least one second shelf. Therefore, in this application, a heat dissipation capability of the electronic device is improved through backplane-free design of the electronic device, and an additional chip does not need to be used to resolve a high-speed link problem. In addition, flexibility, convenience, and cost-effectiveness of shelf stacking and expansion of the electronic device can be further improved.

## Description

### CROSS-REFERENCE TO RELATED APPLICATIONS

This application claims priority to Chinese Patent Application No. 202310365954.1, filed with the China National Intellectual Property Administration on March 30, 2023 and entitled "ELECTRONIC DEVICE AND HEAT DISSIPATION SYSTEM", which is incorporated herein by reference in its entirety.

### TECHNICAL FIELD

This application relates to the field of server technologies, and in particular, to an electronic device and a heat dissipation system.

### BACKGROUND

In a conventional technology, in a case in which an electronic device includes a plurality of central processing units (central processing units, CPUs), the plurality of CPUs are connected through a backplane, and the plurality of CPUs are all located in a same shelf of the electronic device. In addition, the electronic device may further include a plurality of types of processors (represented by xPUs), such as a graphics processing unit (graphics processing unit, GPU) and a neural-network processing unit (neural-network processing unit, NPU). The CPU and the xPU are also connected through the backplane, and the CPU and the xPU are also located in a same shelf of the electronic device.

For example, it is assumed that the electronic device includes four CPUs and eight xPUs, the four CPUs and the eight xPUs are all located in a same shelf of the electronic device, the four CPUs are used as one computing node, and the eight xPUs are used as another computing node. Although the four CPUs and the eight xPUs may be connected through the backplane in the shelf, design of the backplane affects heat dissipation of the electronic device. In addition, because a loss of signal integrity (signal integrity, SI) is too high, a retimer chip needs to be added to the electronic device to resolve a high-speed link problem.

### SUMMARY

In view of this, this application provides an electronic device and a heat dissipation system, to improve a heat dissipation capability of the electronic device. In addition, an additional chip does not need to be used to resolve a high-speed link problem.

According to a first aspect, this application provides an electronic device, including: a plurality of shelves, where each shelf includes a first processor, a first mainboard, and a connector. The first mainboard in any shelf is separately connected to the first processor and the connector that are located in the same shelf. The connector in a first shelf is separately connected to the connector in at least one second shelf. The first shelf is any shelf in the plurality of shelves, and the at least one second shelf is a shelf other than the first shelf in the plurality of shelves.

In comparison with a conventional technology, in this application, a heat dissipation capability of the electronic device is improved through backplane-free design, and an additional chip does not need to be used to resolve a high-speed link problem. In addition, this solution can further improve flexibility, convenience, and cost-effectiveness of shelf stacking and expansion of the electronic device, simplify component configuration of the shelves of the electronic device, and facilitate maintenance of the electronic device.

In a possible design, a quantity of first processors in each shelf is the same; or a quantity of first processors in each shelf is determined according to a first target proportion.

In this application, the first processors included in the electronic device may be evenly distributed to each shelf, so that an overall weight of the electronic device is balanced; or may be distributed to each shelf according to the first target proportion of the quantity of first processors included in the electronic device, to obtain shelves with a plurality of different configurations, thereby improving space utilization of the shelves.

In a possible design, each shelf further includes a pull-up power supply, and the connector in each shelf includes a first pin and a second pin. The first pin of the connector in any shelf is separately connected to the first mainboard and the pull-up power supply that are located in the same shelf, and the second pin of the connector in any shelf is grounded. The second pin of the connector in the first shelf is further connected to the first pin of the connector in the at least one second shelf.

In this application, connection manners of the first pin and the second pin of the connector in each shelf are arranged, so that master and slave shelves can be determined in the plurality of shelves according to a status of the first pin and a status of the second pin of the connector in each shelf.

In a possible design, each shelf further includes a baseboard management controller, the baseboard management controller in any shelf is connected to the first mainboard located in the same shelf, and the baseboard management controller in the first shelf is further connected to the baseboard management controller in the at least one second shelf.

In this application, the baseboard management controller in the first shelf is arranged to be connected to the baseboard management controller in the at least one second shelf, so that management information of each shelf can be obtained by using only the first shelf, and an operation is simple.

In a possible design, each shelf further includes: a second processor and a second mainboard; and the second mainboard in any shelf is separately connected to the first mainboard, the second processor, and the connector that are located in the same shelf.

In this application, each shelf further includes the second processor and the second mainboard, so that different types of electronic devices may be obtained, and different processing functions are implemented by using different types of electronic devices.

In a possible design, a quantity of second processors in each shelf is the same, or a quantity of second processors in each shelf is determined according to a second target proportion.

In this application, the second processors included in the electronic device may be evenly distributed to each shelf, so that the overall weight of the electronic device is balanced; or may be distributed to each shelf according to the second target proportion of the quantity of second processors included in the electronic device, to obtain shelves with a plurality of different configurations. In this way, the second processors in the shelves are properly distributed, thereby improving space utilization of the shelves. In addition, the design may further improve flexibility, convenience, and cost-effectiveness of shelf stacking and expansion of the electronic device.

In a possible design, the connection between the second mainboard in any shelf and the first mainboard located in the same shelf is a cable connection, and the connector of each shelf is connected to that of another shelf via a cable.

In this application, the connection between the second mainboard in any shelf and the first mainboard located in the same shelf is a cable connection, thereby avoiding backplane connection design of a conventional technology and solving the high-speed link problem without needing a retimer chip. The connector in each shelf is arranged to be connected to that of another shelf via a cable, thereby implementing flexible shelf stacking and expansion of a server. A quantity of shelves of the electronic device may be further determined according to an actual requirement, thereby improving space utilization of the shelves.

In a possible design, each shelf further includes a pull-up power supply, and the connector in each shelf includes a first pin and a second pin. The first pin of the connector in any shelf is separately connected to the first mainboard, the second mainboard, and the pull-up power supply that are located in the same shelf, and the second pin of the connector in any shelf is grounded. The second pin of the connector in the first shelf is further connected to the first pin of the connector in the at least one second shelf.

In this application, connection manners of the first pin and the second pin of the connector in each shelf are arranged, so that master and slave shelves can be determined in the plurality of shelves according to a status of the first pin and a status of the second pin of the connector in each shelf.

In a possible design, each shelf further includes a baseboard management controller, the baseboard management controller in any shelf is connected to the first mainboard and the second mainboard that are located in the same shelf, and the baseboard management controller in the first shelf is further connected to the baseboard management controller in the at least one second shelf.

In this application, the baseboard management controller in the first shelf is arranged to be connected to the baseboard management controller in the at least one second shelf, so that management information of each shelf can be obtained by using only the first shelf, and an operation is simple.

In a possible design, the first processor is a central processing unit, and the second processor is any one of a graphics processing unit, a neural-network processing unit, a tensor processing unit, and a deep-learning processing unit. Diversified electronic device shelves may be obtained by arranging different processor types for the first processor and the second processor.

In a possible design, when the electronic device includes two shelves, the first shelf and the second shelf both further includes a clock signal buffer and a clock chip. The clock signal buffer in each shelf includes a third interface and a fourth interface, and the clock chip in each shelf includes a fifth interface and a sixth interface. The third interface of the clock signal buffer in any shelf is connected to the fifth interface of the clock chip located in the same shelf. The fourth interface of the clock signal buffer in the first shelf is connected to the sixth interface of the clock chip in the second shelf. The fourth interface of the clock signal buffer in the second shelf is connected to the sixth interface of the clock chip in the first shelf.

In this application, a manner of connection between clock chips and clock signal buffers of the master and slave shelves is arranged, so that the clock chips of the master and slave shelves can automatically switch clock signals, thereby implementing a same clock source for the master and slave shelves.

According to a second aspect, this application provides a heat dissipation system, including the electronic device according to the first aspect or any design of the first aspect. Each shelf of the electronic device further includes a heat sink, and the first processor in any shelf is connected to the heat sink located in the same shelf.

In this application, a heat dissipation capability of the electronic device in the heat dissipation system is improved through backplane-free design, and a retimer chip does not need to be used to resolve a high-speed link problem. In this design, a quantity of shelves of the electronic device may be further determined according to an actual requirement, thereby improving space utilization of the shelves in the heat dissipation system. In addition, the design may further improve flexibility, convenience, and cost-effectiveness of shelf stacking and expansion of the electronic device.

According to a third aspect, this application provides a heat dissipation system, including the electronic device according to the first aspect or any design of the first aspect. Each shelf of the electronic device further includes a heat sink, a cooling plate, a heat exchanger, and a pump. The first processor in any shelf is connected to the heat sink located in the same shelf. The second processor in any shelf is connected to the cooling plate located in the same shelf. The heat exchanger in any shelf is connected to the pump and the cooling plate that are located in the same shelf.

In this application, a heat dissipation capability of the electronic device in the heat dissipation system is improved through backplane-free design, and a retimer chip does not need to be used to resolve a high-speed link problem. In this design, a quantity of shelves of the electronic device may be further determined according to an actual requirement, thereby improving space utilization of the shelves in the heat dissipation system. In addition, the design may further improve flexibility, convenience, and cost-effectiveness of shelf stacking and expansion of the electronic device. Furthermore, in this application, an area to be occupied by the heat exchanger in the heat dissipation system may be increased through component design of the shelves, thereby improving a heat dissipation capability of the electronic device in the heat dissipation system.

### BRIEF DESCRIPTION OF DRAWINGS

FIG. 1 is a diagram of a shelf structure of a server according to a conventional technology;
FIG. 2A and FIG. 2B are structural diagrams of a plurality of shelves of an electronic device according to an embodiment of this application;
FIG. 3 is a diagram of a process of interaction between a BMC 207 in a first shelf 204 and a BMC 207 in a second shelf 301 according to an embodiment of this application;
FIG. 4A and FIG. 4B are diagrams of a master shelf and a slave shelf that have a same clock source according to an embodiment of this application;
FIG. 5A and FIG. 5B are structural diagrams of a plurality of shelves of an electronic device according to an embodiment of this application;
FIG. 6 is a diagram of a structure of a heat dissipation system according to an embodiment of this application; and
FIG. 7 is a diagram of a structure of a heat dissipation system according to an embodiment of this application.

### DESCRIPTION OF EMBODIMENTS

To make a person of ordinary skill in the art understand technical solutions in this application better, the following clearly and completely describes the technical solutions in embodiments of this application with reference to the accompanying drawings.

It should be noted that, in this specification, claims, and the accompanying drawings of this application, the terms "first", "second", and the like are intended to distinguish similar objects but do not necessarily indicate a specific order or sequence. It should be understood that data used in such a way is interchangeable in a proper circumstance, so that embodiments of this application described herein can be implemented in an order other than the order illustrated or described herein. Implementations described in the following example embodiments do not represent all implementations consistent with this application. On the contrary, the implementations are merely examples of apparatuses and methods that are described in the appended claims in detail and that are consistent with some aspects of this application.

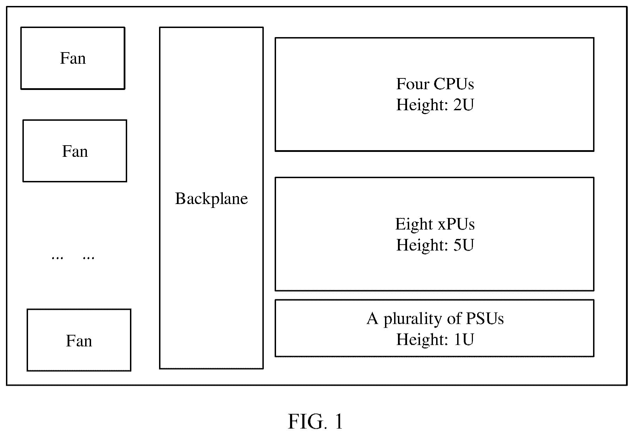

An example in which an electronic device is a server is used for description. In a case, a server in a conventional technology includes a plurality of CPUs, the plurality of CPUs are connected through a backplane, and the plurality of CPUs are all located in a same shelf of the server. In addition, the server may further include a plurality of processor (represented by xPU) types, such as a GPU and an NPU. The CPU and the xPU are also connected through the backplane, and the CPU and the xPU are also located in a same shelf of the server. As shown in FIG. 1, the server includes four CPUs, eight xPUs, and a plurality of power supply units (power supply units, PSUs). A height of the four CPUs each is represented by 2U, a height of the eight xPUs each is represented by 5U, and a height of the plurality of PSUs each is represented by 1U. The four CPUs and the eight xPUs are connected through the backplane, and the server in FIG. 1 further includes a plurality of fans.

FIG. 1 is still used as an example for description. It is assumed that the server includes four CPUs and eight xPUs, the four CPUs and the eight xPUs are all located in a same shelf of the server, the four CPUs serve as a computing node, and the eight xPUs serve as another computing node. Although the four CPUs and the eight xPUs can be connected through the backplane in the shelf, design of the backplane affects heat dissipation of the server. In addition, because an SI loss is too large, a retimer chip needs to be added to the server to resolve a high-speed link problem. In addition, when there are a large quantity of xPUs in the server and the CPUs and the xPUs are in a same shelf of the server, an overall system weight of the server is not evenly distributed, and the computing node on which the CPUs are located and the computing node on which the xPUs are located need to be separately maintained through drawer pluggable design. In addition, for an application scenario in which two CPUs and four xPUs are needed, the server whose configuration information is four CPUs and eight xPUs has a small shelf space and low shelf resource utilization.

In view of this, embodiments of this application provide an electronic device and a heat dissipation system. In this application, a heat dissipation capability of the electronic device is improved through backplane-free design, and a retimer chip does not need to be used to resolve the high-speed link problem. In addition, this solution may further improve flexibility, convenience, and cost-effectiveness of shelf stacking and expansion of the electronic device.

To make the objectives, technical solutions, and advantages of this application clearer, the following further describes this application in detail with reference to the accompanying drawings.

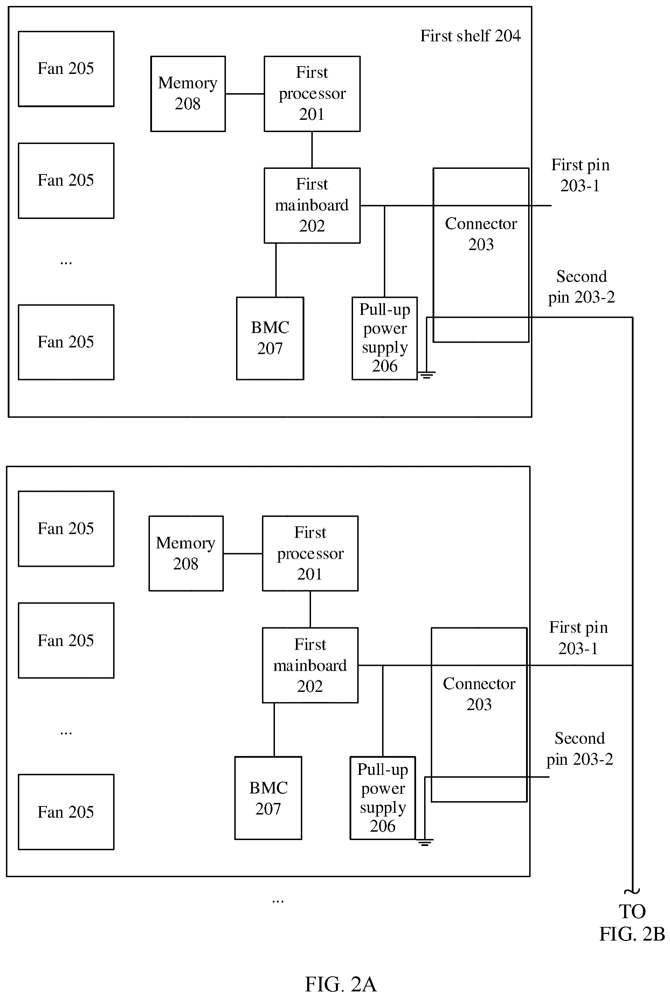

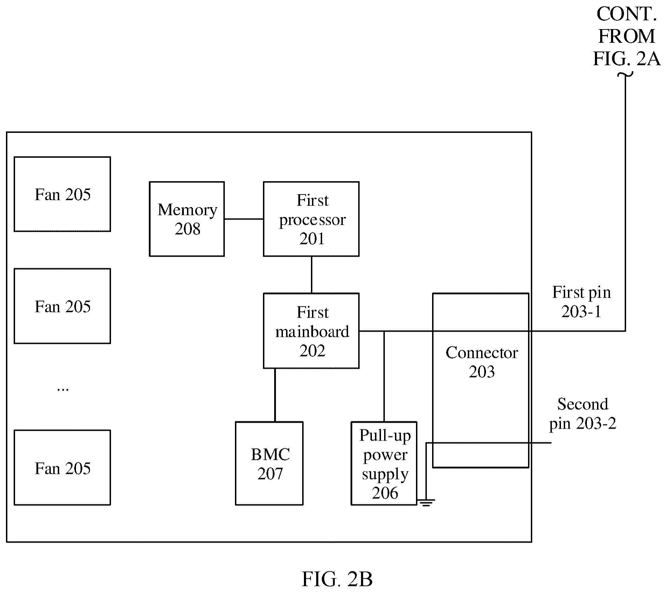

As shown in FIG. 2A and FIG. 2B, the electronic device includes a plurality of shelves, where each shelf includes a first processor 201, a first mainboard 202, and a connector 203. The first mainboard 202 in any shelf is separately connected to the first processor 201 and the connector 203 that are located in the same shelf. The connector 203 in a first shelf 204 is separately connected to the connector 203 in at least one second shelf. The first shelf 204 is any shelf in the plurality of shelves, and the at least one second shelf is a shelf other than the first shelf 204 in the plurality of shelves. A quantity of first processors 201 in each shelf may be determined based on a quantity of first processors included in the electronic device. Each shelf in FIG. 2A and FIG. 2B further includes a plurality of fans 205. The connector 203 of each shelf may be connected to that of another shelf via a cable. Optionally, a quantity of fans 205 in each shelf may be determined based on an actual situation.

Optionally, the quantity of first processors 201 in each shelf is the same, or the quantity of first processors 201 in each shelf is determined according to a first target proportion. It should be learned that a specific value of the first target proportion is not limited in this application.

It is assumed that the electronic device includes four CPUs and eight xPUs, and the electronic device includes two shelves, namely, the first shelf and the second shelf. The first shelf and the second shelf both may include two CPUs and four xPUs; or the first shelf includes three CPUs and six xPUs, and the second shelf includes one CPU and two xPUs. When a requirement is two CPUs and four xPUs, computing may be performed by using the two CPUs and the four xPUs in the first shelf, or may be performed by using the two CPUs and the four xPUs in the second shelf, to avoid simultaneous computing by using the four CPUs and the eight xPUs included in the electronic device, thereby improving shelf space utilization of the electronic device. In addition, when there is a requirement for larger-scale computing, cable connection may be performed for the connectors 203 in the plurality of shelves of the electronic device, to expand a processing capability of the electronic device by stacking different quantities of shelves.

In a possible embodiment, as shown in FIG. 2A and FIG. 2B, each shelf further includes a pull-up power supply 206, and the connector 203 in each shelf includes a first pin 203-1 and a second pin 203-2. The first pin 203-1 of the connector 203 in any shelf is separately connected to the first mainboard 202 and the pull-up power supply 206 that are located in the same shelf, and the second pin 203-2 of the connector 203 in any shelf is grounded. The second pin 203-2 of the connector 203 in the first shelf 204 is further connected to the first pin 203-1 of the connector 203 in the at least one second shelf.

Because the first pin 203-1 of the connector 203 in each shelf is connected to the pull-up power supply 206, the first pin 203-1 of the connector 203 in each shelf is in a high-level state. Because the second pin 203-2 of the connector 203 in each shelf is grounded, the second pin 203-2 of the connector 203 in each shelf is in a low-level state. Further, because the second pin 203-2 of the connector 203 in the first shelf 204 is separately connected to the first pin 203-1 of the connector 203 in the at least one second shelf, the first pin 203-1 of the connector 203 in the at least one second shelf is adjusted from the high level state to the low level state.

In a possible embodiment, each shelf further includes a baseboard management controller (baseboard management controller, BMC) 207, the baseboard management controller 207 in any shelf is connected to the first mainboard 202 located in the same shelf, and the baseboard management controller 207 in the first shelf 204 is further connected (not shown in FIG. 2A and FIG. 2B) to the baseboard management controller 207 in the at least one second shelf.

The first mainboard 202 in each shelf may include a programmable logic device (complex programmable logic device, CPLD), and the CPLD in the first mainboard 202 in any shelf is connected to the first processor 201, the BMC 207, and the connector 203 that are in the same shelf. The CPLD in the first mainboard 202 in any shelf may determine master and slave shelves in the plurality of shelves according to the status of the first pin 203-1 and the status of the second pin 203-2 of the connector 203 in the same shelf. For example, in FIG. 2A and FIG. 2B, the first shelf 204 is a master shelf, and all of the other shelves are slave shelves. The baseboard management controller 207 in the first shelf 204 is further connected to the baseboard management controller 207 in the at least one second shelf, and information about each of the at least one second shelf may be obtained through the first shelf 204, so that a user may perform a management operation on the electronic device via a standard command interface IPMI in the first shelf 204. Here, the BMC 207 in any shelf may automatically complete software configuration based on the CPLD of the first mainboard 202 in the same shelf. It should be learned that a specific software configuration is not limited herein.

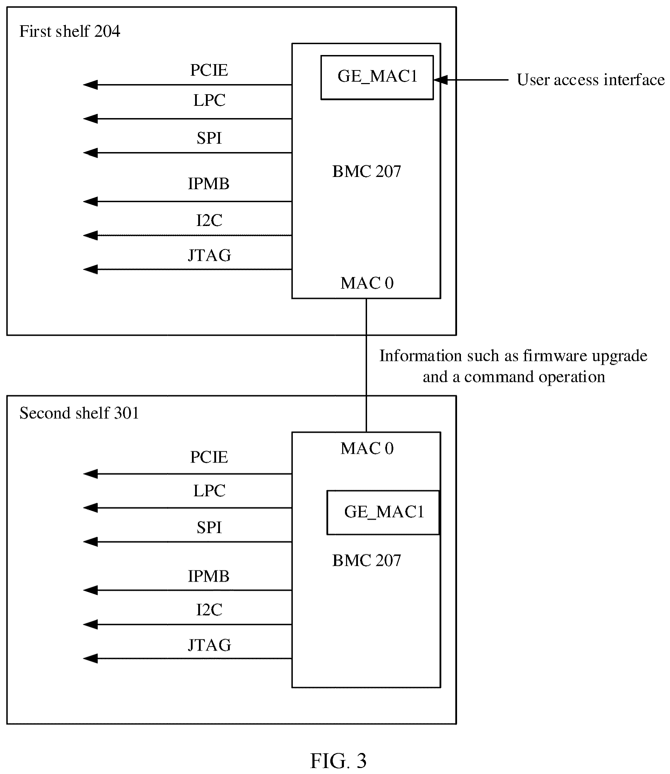

For example, as shown in FIG. 3, a process of interaction between the BMCs 207 in the shelves is described by using an example in which the electronic device includes the first shelf 204 and the second shelf 301. In the first shelf 204, the BMC 207 may interact with the first mainboard 202 through a protocol, such as the peripheral component interconnect express (peripheral component interconnect express, PCIE) protocol, a link protocol converter (link protocol converter, LPC), a serial peripheral interface (serial peripheral interface, SPI), an intelligent platform management bus (intelligent platform management bus, IPMB), an inter-integrated circuit (inter-integrated circuit, I2C) bus, or Joint Test Action Work (Joint Test Action Group, JTAG). Similarly, in the second shelf 301, the BMC 207 may interact with the first mainboard 202 through a protocol, such as PCIE, LPC, SPI, IPMB, I2C or JTAG. In addition, the first shelf 204 may further obtain, from MAC 0 of the BMC 207 in the second shelf 301, management information of the second shelf 301 by using the MAC 0 of the BMC 207, for example, information such as firmware upgrade and a command operation. Herein, the user may access a GE_MAC1 interface of the BMC 207 in the first shelf 204.

Herein, the first processor 201 in each shelf may be a CPU. After it is determined that the first shelf 204 is a master shelf and all of the other shelves are slave shelves, the first processor 201 in the first shelf 204 may be defined as a CPU 0, and the first processors 201 in the other shelves may be defined as CPU 1, ..., CPU X, where X is a positive integer greater than or equal to 1. The CPU 0 in the master shelf, namely, the first shelf 204, may start a basic input/output system (basic input/output system, BIOS) in the shelf, and then store data in a memory flash 208. In this case, the CPU 1, ..., and CPU X in the slave shelves are automatically prohibited from starting BIOSs in the corresponding shelves.

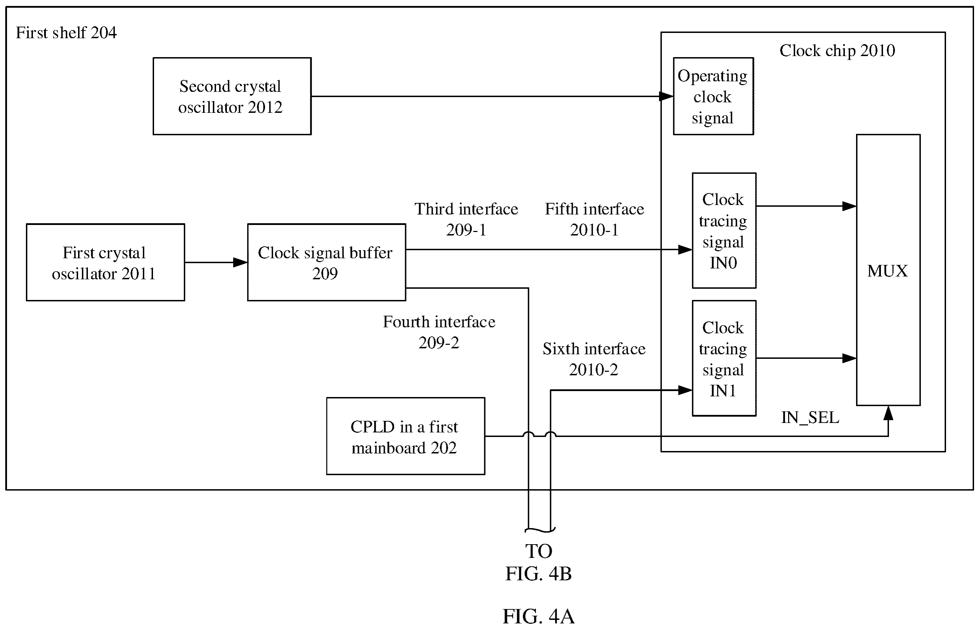

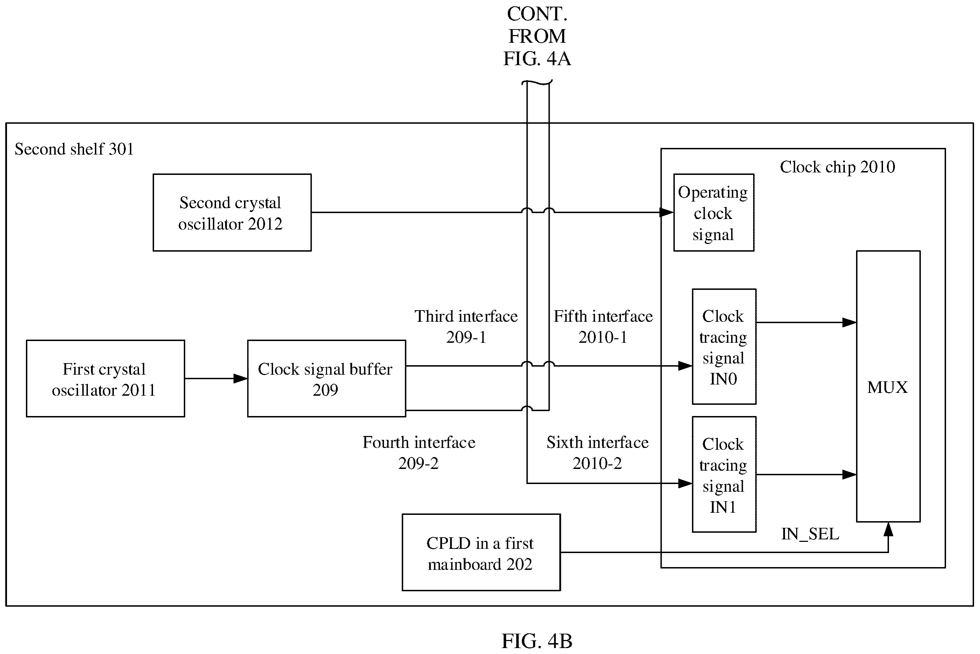

As shown in FIG. 4A and FIG. 4B, for a case in which the electronic device includes the first shelf 204 and the second shelf 301, the first shelf 204 and the second shelf 301 both further include a clock signal buffer 209 and a clock chip 2010. The clock signal buffer 209 in each shelf includes a third interface 209-1 and a fourth interface 209-2, and the clock chip 2010 in each shelf includes a fifth interface 2010-1 and a sixth interface 2010-2. The third interface 209-1 of the clock signal buffer 209 in any shelf is connected to the fifth interface 2010-1 of the clock chip 2010 located in the same shelf. The fourth interface 209-2 of the clock signal buffer 209 in the first shelf 204 is connected to the sixth interface 2010-2 of the clock chip 2010 in the second shelf 301. The fourth interface 209-2 of the clock signal buffer 209 in the second shelf 301 is connected to the sixth interface 2010-2 of the clock chip 2010 in the first shelf 204.

Each shelf further includes a first crystal oscillator 2011 and a second crystal oscillator 2012. The clock chip 2010 in any shelf operates normally by using an operating clock signal sent by the second crystal oscillator 2012 in the same shelf. When the first shelf 204 performs computing independently, the first crystal oscillator 2011 in the first shelf 204 sends a clock tracing signal IN0 to the clock chip 2010 through the clock signal buffer 209, the CPLD in the first mainboard 202 sends a signal IN_SEL to the clock chip 2010, and the clock chip 2010 processes the clock tracing signal IN0 and the signal IN_SEL through an MUX. Herein, a specific signal processing manner is not limited in this application. Similarly, when the second shelf 301 performs computing independently, the first crystal oscillator 2011 in the second shelf 301 sends a clock tracing signal IN0 to the clock chip 2010 through the clock signal buffer 209, the CPLD in the first mainboard 202 sends a signal IN_SEL to the clock chip 2010, and the clock chip 2010 processes the clock tracing signal IN0 and the signal IN_SEL through an MUX.

When the first shelf 204 serving as a master shelf and the second shelf 301 serving as a slave shelf perform computing, on a basis of the computing independently performed by the first shelf 204 and the computing independently performed by the second shelf 301 as described previously, the clock signal buffer 209 in the first shelf 204 further sends a clock tracing signal IN1 to the clock chip 2010 in the second shelf 301, and the clock chip 2010 in the second shelf 301 processes the clock tracing signal IN0, the clock tracing signal IN1, and the signal IN_SEL through the MUX. Similarly, the clock signal buffer 209 in the second shelf 301 further sends a clock tracing signal IN1 to the clock chip 2010 in the first shelf 204, and the clock chip 2010 in the first shelf 204 processes the clock tracing signal IN0, the clock tracing signal IN1, and the signal IN_SEL through the MUX.

Herein, the first processor 201 and the BMC 207 in any shelf may be disposed on the first mainboard 202 in the same shelf. This is merely an example for description herein. This application does not limit a specific manner of connection between the first processor 201, the BMC 207, and the first mainboard 202 in any shelf.

In this way, a manner of connection between clock chips and clock signal buffers of the master and slave shelves is arranged, so that the clock chips of the master and slave shelves can automatically switch clock signals, thereby implementing a same clock source for the master and slave shelves.

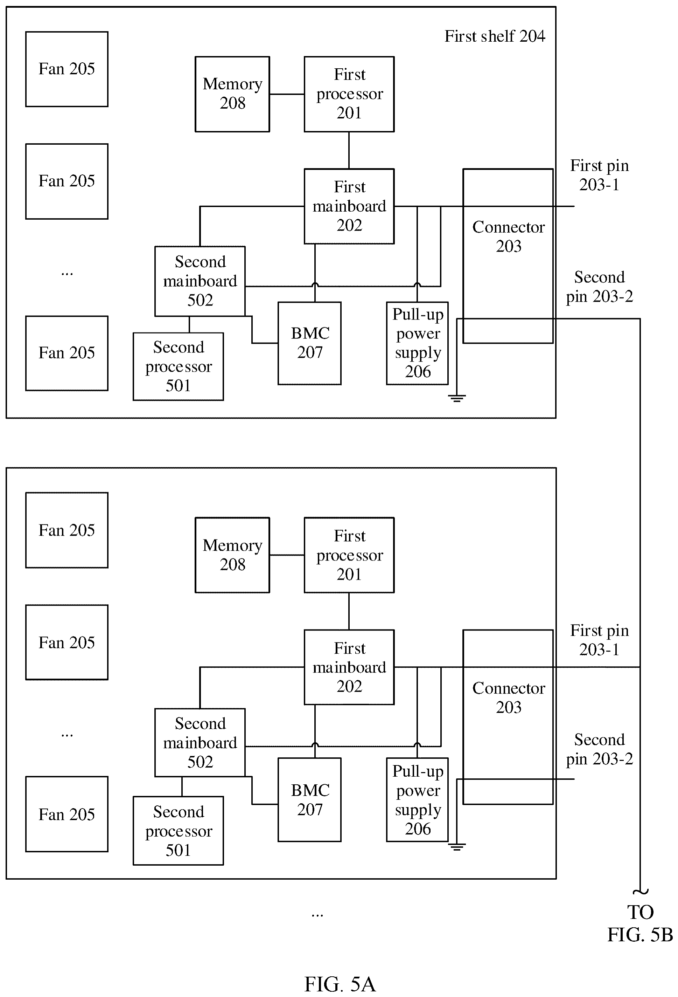

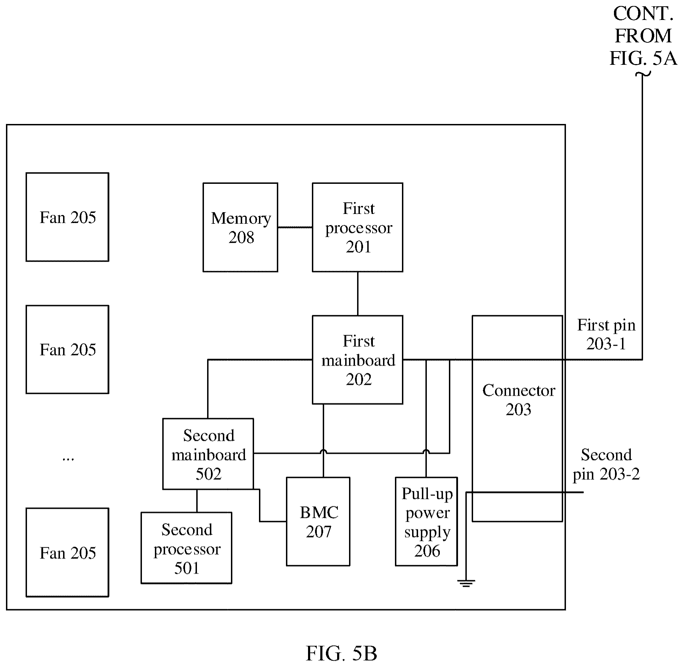

In a possible embodiment, on a basis of the electronic device shown in FIG. 2A and FIG. 2B, as shown in FIG. 5A and FIG. 5B, each shelf of the electronic device may further include a second processor 501 and a second mainboard 502. The second mainboard 502 in any shelf is separately connected to the first mainboard 202, the second processor 501, and the connector 203 that are located in the same shelf. A quantity of second processors 501 in each shelf may be determined based on a quantity of second processors included in the electronic device. The connection between the second mainboard 502 in any shelf and the first mainboard 202 located in the same shelf is a cable connection, and the connector 203 of each shelf is connected to that of another shelf via a cable.

Optionally, the quantity of second processors 501 in each shelf is the same, or the quantity of second processors 501 in each shelf is determined according to the second target proportion.

In a possible embodiment, each shelf further includes a pull-up power supply 206, and the connector 203 in each shelf includes a first pin 203-1 and a second pin 203-2. The first pin 203-1 of the connector 203 in any shelf is separately connected to the first mainboard 202, the second mainboard 502, and the pull-up power supply 206 that are located in the same shelf, and the second pin 203-2 of the connector 203 in any shelf is grounded. The second pin 203-2 of the connector 203 in the first shelf 204 is further connected to the first pin 203-1 of the connector 203 in the at least one second shelf.

In a possible embodiment, each shelf further includes a baseboard management controller 207, the baseboard management controller 207 in any shelf is connected to the first mainboard 202 and the second mainboard 502 that are located in the same shelf, and the baseboard management controller 207 in the first shelf 204 is further connected to the baseboard management controller 207 in the at least one second shelf.

Herein, the second processor 501 may be any one of a graphics processing unit GPU, a neural-network processing unit NPU, a tensor processing unit (tensor processing unit, TPU), or a deep-learning processing unit (deep-learning processing unit, DPU).

For a specific implementation in this embodiment, refer to the description corresponding to FIG. 2A and FIG. 2B. Details are not described herein again.

An embodiment of this application may further provide a heat dissipation system, including the electronic device in any one of the foregoing solutions, where each shelf of the electronic device further includes a heat sink. The first processor in any shelf is connected to the heat sink located in the same shelf; or the first processor and the second processor in any shelf are both connected to the heat sink located in the same shelf. Herein, a quantity of heat sinks in any shelf may be the same as a quantity of first processors in the same shelf; or a quantity of heat sinks in any shelf may be the same as a total quantity of first processors and second processors in the same shelf.

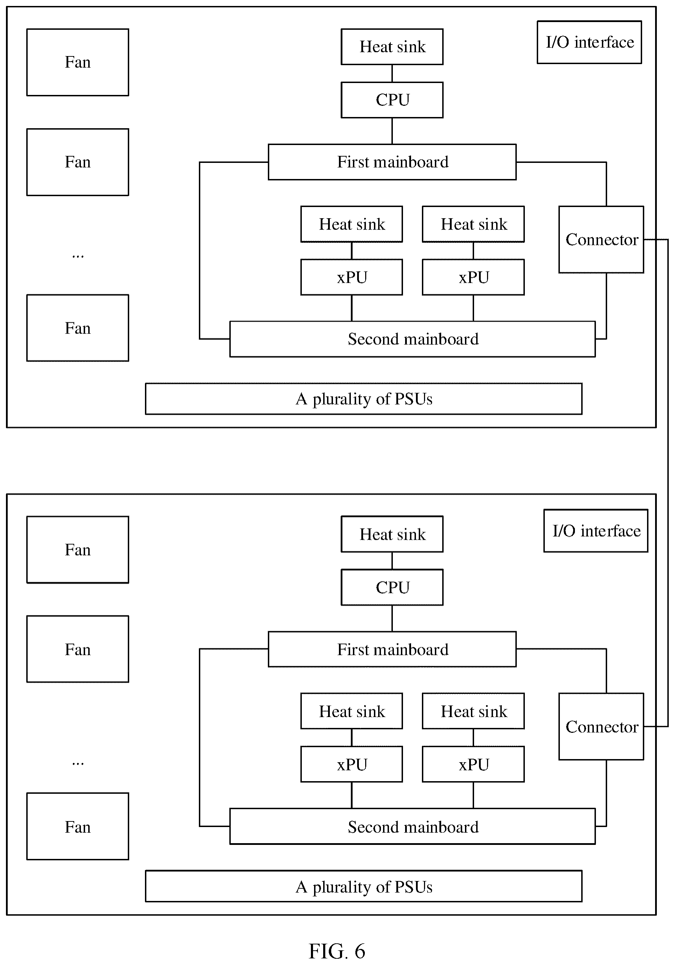

As shown in FIG. 6, it is assumed that the electronic device in the heat dissipation system includes two shelves, and the two shelves both include one CPU, two xPUs, a plurality of PSUs, a connector, a first mainboard, a second mainboard, a heat sink, and an I/O interface. The CPU and the xPUs in any shelf are connected to the heat sink in the same shelf. The quantity of heat sinks is the same as the total quantity of the CPU and the two xPUs. The CPU in each shelf is further connected to the first mainboard, and the two xPUs are both connected to the second mainboard. The first mainboard and the second mainboard are connected via a cable, and the first mainboard and the second mainboard are further connected to the connector. The two shelves are connected via their respective connectors. Heat dissipation is performed through fans for the heat dissipation system in a pure air cooling manner.

Herein, the electronic device may be a server, and each shelf may further include a plurality of fans. A quantity of fans may be determined based on an actual situation.

As power consumption of the second processor xPU becomes higher, if the heat dissipation system in the pure air cooling manner cannot satisfy a heat dissipation problem of the electronic device, a hybrid air-liquid heat dissipation system based on liquid-assisted air cooling (liquid-assisted air cooling, LAAC) heat dissipation under an air-cooled equipment room condition may further improve a heat dissipation capability of the electronic device.

An embodiment of this application may further provide a heat dissipation system, including the electronic device in any one of the foregoing solutions, where each shelf of the electronic device further includes a heat sink, a cooling plate, a heat exchanger (heat exchanger, HEX), and a pump. The first processor in any shelf is connected to the heat sink located in the same shelf, the second processor in any shelf is connected to the cooling plate located in the same shelf, and the heat exchanger in any shelf is connected to the pump and the cooling plate that are located in the same shelf. Herein, a quantity of heat sinks in any shelf may be the same as a quantity of first processors in the same shelf, and a quantity of cooling plates in any shelf may be the same as a quantity of second processors in the same shelf.

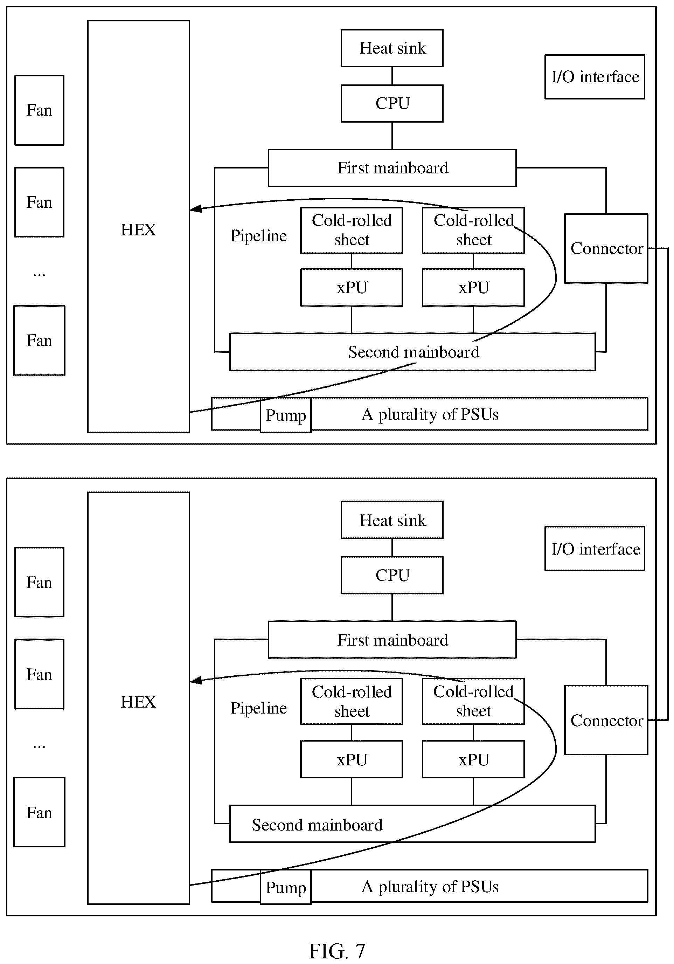

As shown in FIG. 7, it is assumed that the electronic device in the heat dissipation system includes two shelves, and the two shelves both include one CPU, two xPUs, a plurality of PSUs, a connector, a first mainboard, a second mainboard, a heat sink, cooling plates, a heat exchanger, a pump, and an I/O interface. In each shelf, the CPU is connected to the heat sink, and a quantity of heat sinks is the same as the quantity of the CPU. In each shelf, the xPU is connected to the cooling plate, and a quantity of cooling plates is the same as the quantity of the two xPUs. In each shelf, the CPU is further connected to the first mainboard, and the two xPUs are both connected to the second mainboard. The first mainboard and the second mainboard are connected via a cable, and the first mainboard and the second mainboard are further connected to the connector. The two shelves are connected via their respective connectors. Heat dissipation is performed on the heat dissipation system by using a plurality of fans and the HEXs. It should be learned that a direction shown in FIG. 7 is a direction of heat dissipation after the HEX, the pump, and the cooling plate are connected through a pipeline. This is merely an example for description herein.

It is clear that a person skilled in the art may make various modifications and variations to this application without departing from the spirit and scope of this application. This application is intended to cover the modifications and variations of this application provided that these modifications and variations fall within the scope of protection defined by the claims of this application and their equivalent technologies.

## Claims

1. An electronic device, comprising a plurality of shelves, wherein each shelf comprises: a first processor, a first mainboard, and a connector; and the first mainboard in any shelf is separately connected to the first processor and the connector that are located in the same shelf;
the connector in a first shelf is separately connected to the connector in at least one second shelf; and
the first shelf is any shelf in the plurality of shelves, and the at least one second shelf is a shelf other than the first shelf in the plurality of shelves.

2. The electronic device according to claim 1, wherein a quantity of first processors in each shelf is the same; or a quantity of first processors in each shelf is determined according to a first target proportion.

3. The electronic device according to claim 1 or 2, wherein each shelf further comprises a pull-up power supply, and the connector in each shelf comprises a first pin and a second pin; the first pin of the connector in any shelf is separately connected to the first mainboard and the pull-up power supply that are located in the same shelf, and the second pin of the connector in any shelf is grounded; and the second pin of the connector in the first shelf is further connected to the first pin of the connector in the at least one second shelf.

4. The electronic device according to any one of claims 1 to 3, wherein each shelf further comprises a baseboard management controller, the baseboard management controller in any shelf is connected to the first mainboard located in the same shelf, and the baseboard management controller in the first shelf is further connected to the baseboard management controller in the at least one second shelf.

5. The electronic device according to any one of claims 1 to 4, wherein the first processor is a central processing unit.

6. The electronic device according to claim 1 or 2, wherein each shelf further comprises: a second processor and a second mainboard; and the second mainboard in any shelf is separately connected to the first mainboard, the second processor, and the connector that are located in the same shelf.

7. The electronic device according to claim 6, wherein a quantity of second processors in each shelf is the same, or a quantity of second processors in each shelf is determined according to a second target proportion.

8. The electronic device according to claim 6 or 7, wherein the connection between the second mainboard in any shelf and the first mainboard located in the same shelf is a cable connection, and the connector of each shelf is connected to that of another shelf via a cable.

9. The electronic device according to any one of claims 6 to 8, wherein each shelf further comprises a pull-up power supply, and the connector in each shelf comprises a first pin and a second pin; the first pin of the connector in any shelf is separately connected to the first mainboard, the second mainboard, and the pull-up power supply that are located in the same shelf, and the second pin of the connector in any shelf is grounded; and the second pin of the connector in the first shelf is further connected to the first pin of the connector in the at least one second shelf.

10. The electronic device according to any one of claims 6 to 9, wherein each shelf further comprises a baseboard management controller, the baseboard management controller in any shelf is connected to the first mainboard and the second mainboard that are located in the same shelf, and the baseboard management controller in the first shelf is further connected to the baseboard management controller in the at least one second shelf.

11. The electronic device according to any one of claims 6 to 10, wherein the second processor is any one of a graphics processing unit, a neural-network processing unit, a tensor processing unit, and a deep-learning processing unit.

12. The electronic device according to any one of claims 1 to 11, wherein when the electronic device comprises two shelves, the first shelf and the second shelf both further comprise a clock signal buffer and a clock chip; the clock signal buffer in each shelf comprises a third interface and a fourth interface, and the clock chip in each shelf comprises a fifth interface and a sixth interface; and the third interface of the clock signal buffer in any shelf is connected to the fifth interface of the clock chip located in the same shelf, the fourth interface of the clock signal buffer in the first shelf is connected to the sixth interface of the clock chip in the second shelf, and the fourth interface of the clock signal buffer in the second shelf is connected to the sixth interface of the clock chip in the first shelf.

13. A heat dissipation system, comprising the electronic device according to any one of claims 1 to 12, wherein each shelf of the electronic device further comprises a heat sink, and the first processor in any shelf is connected to the heat sink located in the same shelf.

14. A heat dissipation system, comprising the electronic device according to any one of claims 1 to 12, wherein each shelf of the electronic device further comprises a heat sink, a cooling plate, a heat exchanger, and a pump; and the first processor in any shelf is connected to the heat sink located in the same shelf, the second processor in any shelf is connected to the cooling plate located in the same shelf, and the heat exchanger in any shelf is connected to the pump and the cooling plate that are located in the same shelf.
